# FASCICULE DE BREVET EUROPEEN

(11) **EP 1 734 587 B1**
(45) Date de publication et mention de la délivrance du brevet: **03.12.2008**
(21) Numéro de dépôt: 05012998.0
(22) Date de dépôt: 16.06.2005
(51) Int. Cl.: H01L 31/0224, H01L 31/18, C03C 17/23

(54) **Procédé de fabrication d'un élément transparent comprenant des électrodes également transparentes et l'élément correspondant**
Herstellungsverfahren für ein transparentes Element mit transparenten Elektroden und entsprechendes Element
Fabrication method for a transparent device having transparent electrodes and such device

(43) Date de publication de la demande: 20.12.2006
(73) Titulaire: ASULAB S.A., 2074 Marin (CH)
(72) Inventeur: Poli, Gian-Carlo, 2206 Les Geneveys/Coffrane (CH); Grupp, Joachim, 2073 Enges (CH)
(74) Mandataire: Thérond, Gérard Raymond

(56) Documents cités:
- EP-A- 0 938 135
- EP-A- 0 969 517
- EP-A- 1 394 640
- EP-A- 1 457 865
- DE-U1- 20 122 323
- GB-A- 784 673
- US-B1- 6 858 352

## Description

La présente invention concerne un procédé de fabrication d'un élément transparent comportant des électrodes également transparentes dont les contours ne doivent pouvoir être discemés par l'oeil humain.

Par "élément transparent", on entend de façon non limitative des verres de lunette, des glaces de montre, des écrans à touches tactiles capacitives par exemple structurées sur des glaces de montre, voire les substrats transparents d'une cellule d'affichage à cristaux liquides ou d'une cellule phetovaitaïque.

A l'heure actuelle, le procédé de structuration des électrodes d'un écran à touches tactiles capacitives consiste à déposer sur un substrat transparent, par exemple en verre, une couche d'oxyde conducteur également transparent tel que de l'oxyde d'indium-étain mieux connu sous sa dénomination anglo-saxonne indium-tin oxyde ou ITO. Après dépôt, on élimine la couche d'ITO sur toute la surface du substrat sous-jacent sauf aux endroits où doivent subsister les électrodes. Le substrat présente ainsi de grandes surfaces dépourvues d'ITO qu'il faut compenser optiquement dans la mesure où les indices de réfraction du substrat et de l'ITO ne sont pas identiques. Cette compensation optique est opérée par dépôt de couches minces non conductrices dont les indices de réfraction sont adaptés à ceux du substrat et de l'ITO. Malgré toutes les précautions prises, ces zones optiquement compensées restent visibles sous certains angles de vue ou dans certaines conditions d'illumination.

Pour remédier à ce problème, il a été proposé de n'enlever l'ITO que le long du contour des électrodes. Une telle solution est connue, par exemple, des documents JP 60-260392 et WO 92/13328. Le détourage des électrodes peut être réalisé par photolithographie ou encore par ablation laser. La largeur du trait de détourage peut être rendue suffisamment mince (environ 20 µm) pour que sa compensation optique par dépôts de couches diélectriques dont les indices optiques sont adaptés ne pose pas de problème particulier. On peut même envisager de rendre le trait de détourage si mince (largeur de l'ordre de 5 µm) que celui-ci soit invisible à l'oeil nu sans qu'il soit nécessaire de prévoir des couches de compensation optique additionnelles.

Toutefois, plus le trait de détourage est mince, plus le risque de voir subsister de petits fragments de matériau conducteur susceptibles d'engendrer des courts-circuits est grand. Pour remédier à ce problème, le document JP 60-260392 propose, après ablation laser, de nettoyer le substrat au moyen d'ultrasons dans un bain de liquide de nettoyage tel que de l'alcool. Or, on cherche habituellement à éviter les traitements en phase humide car ils ralentissent la cadence de fabrication et renchérissent dont les coûts de production.

Un autre inconvénient du procédé susmentionné réside dans le fait qu'il peut se produire des couplages capacitifs parasites entre les électrodes qui sont portées à un potentiel fixe et le reste de la surface d'ITO qui elle est flottante. Or de tels couplages parasites sont susceptibles de perturber le bon fonctionnement de l'écran à touches tactiles capacitives, tout particulièrement lorsque la fréquence du signal d'adressage des électrodes est élevée.

Pour remédier aux problèmes susmentionnés ainsi qu'à d'autres encore, la présente invention procure un procédé de fabrication qui permet notamment de supprimer le nettoyage en phase humide.

A cet effet, la présente invention concerne un procédé de fabrication d'un élément transparent comprenant des électrodes également transparentes, ce procédé comprenant les étapes qui consistent à :
- déposer sur au moins une partie de la surface d'un substrat transparent une couche d'un oxyde conducteur également transparent, et
- structurer dans la couche d'oxyde conducteur au moins une électrode en enlevant ledit oxyde le long du contour de l'électrode recherchée de façon à créer un trait de détourage qui va isoler la partie de la couche d'oxyde conducteur qui constitue l'électrode et qui est destinée à être portée à un potentiel électrique du reste de la couche d'oxyde conducteur qui elle sera flottante,
ce procédé étant caractérisé en ce que l'on réalise au moins un second trait de détourage autour du premier.

Grâce à ces caractéristiques, la présente invention procure un procédé de fabrication d'un élément transparent comprenant des électrodes également transparentes qui permet de détourer ces électrodes selon un trait très fin tout en réduisant considérablement les risques de courts-circuits pouvant résulter d'un tel détourage. En effet, les probabilités qu'il subsiste des particules conductrices susceptibles d'engendrer des courts-circuits lorsqu'on enlève une première, puis une seconde fois l'oxyde conducteur le long du contour des électrodes ne s'additionnent pas mais se multiplient, de sorte que la probabilité résultante est sensiblement inférieure aux probabilités dont elle est le produit. On peut donc réduire la largeur des traits de détourage jusqu'à des valeurs comprises entre 1 µm et 10 µm et de préférence égales à 5 µm, de sorte que de tels traits de détourage sont invisibles à l'oeil nu et ne nécessitent pas d'être impérativement compensées optiquement par des dépôts additionnels de couches de compensation optique non conductrices dont les indices de réfraction seraient adaptés à ceux du substrat et de la couche d'oxyde conducteur. Par ailleurs, un tel procédé permet de réduire les risques de couplages capacitifs parasites entre les zones actives et flottantes de la couche d'oxyde conducteur.

En première approche, on peut se contenter d'enlever l'oxyde le long du contour des électrodes selon un trait de détourage unique, mais il faut malgré tout prendre des mesures pour limiter au maximum les couplages capacitifs parasites.

C'est pourquoi, selon un deuxième aspect, la présente invention concerne un procédé de fabrication d'un élément transparent comprenant des électrodes également transparentes, ce procédé comprenant les étapes consistant à :
- déposer sur au moins une partie de la surface d'un substrat transparent une couche d'un oxyde conducteur également transparent, et
- structurer dans la couche d'oxyde conducteur au moins une électrode en enlevant ledit oxyde le long du contour de l'électrode recherchée de façon à créer un trait de détourage qui va isoler la partie active de la couche d'oxyde conducteur qui constitue l'électrode et qui est destinée à être portée à un potentiel électrique du reste de la couche d'oxyde conducteur qui elle sera flottante,
ce procédé étant caractérisé en ce que l'on segmente la couche d'oxyde conducteur flottante en au moins deux parties distinctes non reliées électriquement entre elles en enlevant ledit oxyde selon un trait de séparation.

Grâce à ces caractéristiques, la présente invention procure un procédé de fabrication d'un élément transparent comprenant des électrodes également transparentes qui permet de réduire sensiblement les risques de couplages capacitifs parasites entre les zones actives de la couche d'oxyde qui constituent les électrodes et qui sont destinées à être portées à un potentiel électrique et les zones de la couche d'oxyde qui sont flottantes, c'est-à-dire qui ne sont reliées à aucun potentiel. Ainsi, il y a moins de risques que les couplages parasites perturbent le bon fonctionnement des électrodes, en particulier lorsque la fréquence du signal d'adressage desdites électrodes est élevée.

La présente invention concerne également un dispositif comprenant un substrat transparent recouvert d'une couche d'oxyde conducteur également transparent dans laquelle est structurée au moins une électrode, un trait de détourage séparant la partie active de la couche d'oxyde conducteur qui constitue l'électrode et qui est portée à un potentiel électrique du reste de la couche d'oxyde conducteur qui elle est flottante, caractérisé en ce qu'il comprend des moyens pour éviter un couplage capacitif parasite entre la partie active et la partie flottante de ladite couche d'oxyde conducteur.

Selon un premier mode de réalisation de l'invention, les moyens pour éviter le couplage capacitif comprennent un second trait de détourage formé autour du premier.

Selon un second mode de réalisation de l'invention, les moyens pour éviter le couplage capacitif comprennent un trait qui segmente la partie flottante de la couche d'oxyde conducteur en au moins deux zones distinctes non reliées électriquement.

D'autres caractéristiques et avantages de la présente invention ressortiront plus clairement de la description détaillée qui suit d'un mode de mise en oeuvre du procédé selon l'invention, cet exemple étant donné à titre purement illustratif et non limitatif seulement en liaison avec le dessin annexé sur lequel :
- la figure 1 est une vue de dessous d'un substrat transparent recouvert d'une couche d'un oxyde conducteur également transparent dans laquelle ont été structurées des électrodes, ces électrodes étant séparées du reste de la couche d'oxyde conducteur par deux traits de détourage concentriques;
- la figure 2 est une vue de détail à plus grande échelle de la zone entourée d'un cercle sur la figure 1;

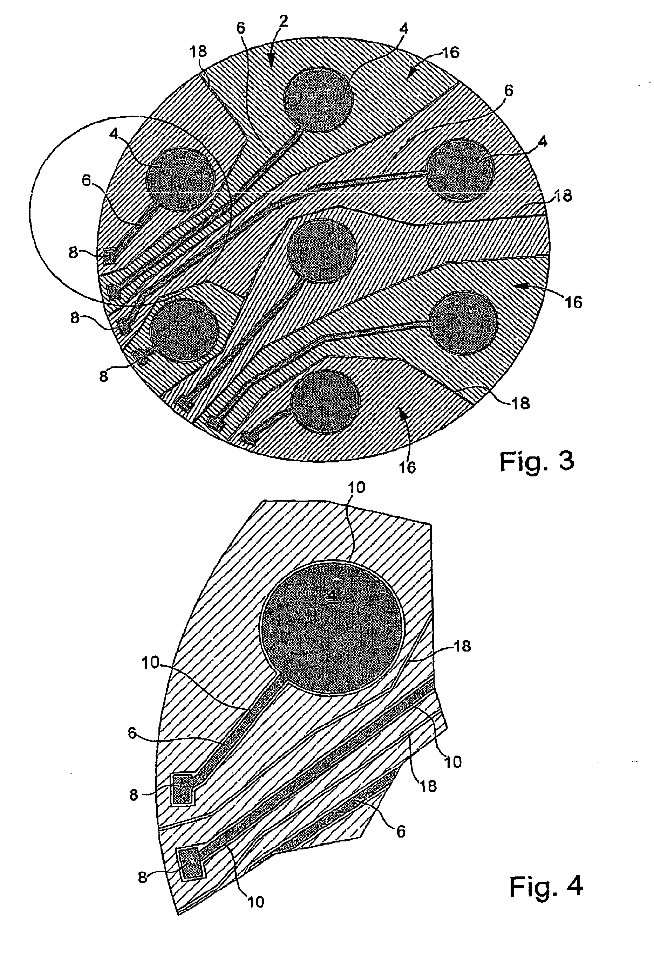

- la figure 3 est une vue analogue à celle de la figure 1, la partie flottante de la couche d'oxyde étant segmentée en une pluralité de régions isolées électriquement les unes des autres;
- la figure 4 est une vue de détail à plus grande échelle de la zone entourée d'un cercle sur la figure 3;
- la figure 5 est une vue de dessous d'une glace de montre dont le pourtour est métallisé, et
- les figures 6A et 6B sont des vues en coupe de la glace de montre représentée à la figure 5 qui illustrent deux modes de réalisation de la couche de métallisation et de la couche d'oxyde conducteur transparent.

La présente invention procède de l'idée générale inventive qui consiste à structurer une couche d'oxyde conducteur transparent déposée sur un substrat lui aussi transparent en enlevant de minces lignes de matière par exemple par ablation laser ou par gravage photolithographique. Cette structuration peut revêtir deux aspects distincts mais toutefois complémentaires : formation d'une seconde ligne de détourage d'électrode autour d'une première ou division de la partie flottante de la couche d'oxyde conducteur en régions électriquement isolées les unes des autres. Le but de l'invention est de réduire les couplages capacitifs parasites entre les zones actives, c'est-à-dire portées à un potentiel électrique, et les zones flottantes, c'est-à-dire qui ne sont reliées à aucun potentiel, de la couche d'oxyde conducteur afin de garantir un bon fonctionnement des électrodes même avec des tensions d'adressage des électrodes de fréquences élevées. Un but supplémentaire est de s'assurer que les électrodes soient invisibles à l'oeil nu sans qu'il soit indispensable de déposer des couches de compensation optique additionnelles.

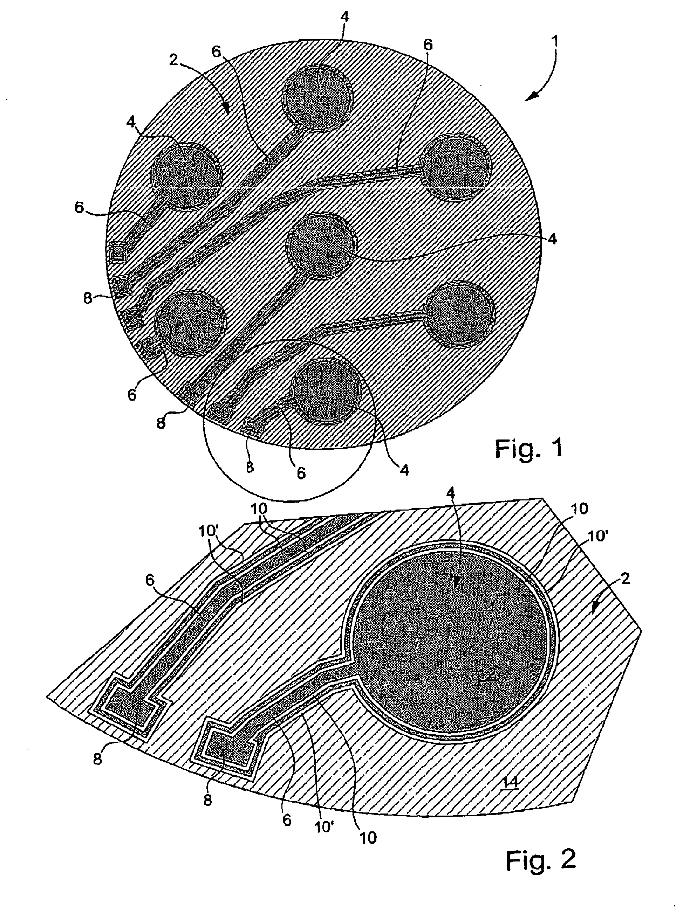

La figure 1 est une vue de dessous d'une glace transparente 1, par exemple en saphir ou en verre trempé, destinée à être montée dans une montre-bracelet (non représentée). Sur la face inférieure de la glace 1 est déposée une couche d'oxyde conducteur 2 également transparente dans laquelle sont structurées des électrodes 4 reliées par des pistes conductrices 6 à des plages de contact périphériques 8. Ces plages de contact 8 sont destinées à être reliées au mouvement électronique de la montre-bracelet ou à un microprocesseur pour commander des fonctions électroniques horaires ou autres de la montre. En effet, les électrodes 4 forment des capteurs tactiles capacitifs qui peuvent être activés par apposition d'un doigt sur la surface extérieure de la glace 2.

Dans une première étape du procédé selon l'invention, on dépose, par exemple par évaporation, sur toute la surface de la glace 1 une couche d'oxyde conducteur transparent tel que de l'oxyde d'étain-indium, mieux connu sous sa dénomination anglo-saxonne "indium-tin oxyde" ou "ITO". L'épaisseur de la couche d'ITO est typiquement comprise entre 25 nm et 75 nm et de préférence entre 45 nm et 55 nm. Il va de soi que cet exemple est donné à titre purement illustratif seulement et que l'oxyde conducteur transparent pourrait également être choisi parmi In₂O₃ et SnO₂ dopé à l'antimoine.

Dans une seconde étape du procédé selon l'invention, on enlève l'ITO le long du contour des électrodes 4, des pistes conductrices 6 et des plages de contact 8. Dans la suite de la description, on ne se référera plus qu'aux électrodes 4 par souci de simplicité, étant entendu que les étapes du procédé qui seront décrites en liaison avec lesdites électrodes 4 s'appliquent pareillement aux pistes conductrices 6 et aux plages de contact 8.

On enlève donc l'ITO le long du contour des électrodes 4 en suivant une ligne de détourage 10 dont la largeur est comprise entre 1 µm et 10 µm et préférentiellement égale à 5 µm afin de ne pouvoir être distinguée à l'oeil nu. L'élimination de l'ITO le long du contour des électrodes 4 peut se faire, par exemple par ablation laser ou encore par photolithographie. En détourant ainsi les électrodes 4, on isole électriquement la partie active 12 de la couche d'ITO qui constitue l'électrode 4 et qui est destinée à être portée à un potentiel électrique du reste 14 de la couche d'ITO qui elle sera flottante, c'est-à-dire qui ne sera pas reliée à un potentiel. Cependant, vu la largeur du trait de détourage des électrodes 4, il existe un risque non négligeable qu'il subsiste de petits fragments d'ITO susceptibles de créer des courts-circuits. C'est pourquoi, conformément à un premier aspect du procédé selon l'invention, on enlève l'ITO le long du contour des électrodes 4 selon une seconde ligne de détourage 10' entourant la première 10, réduisant ainsi considérablement les risques de court-circuit. En effet, les probabilités qu'il subsiste des particules conductrices susceptibles d'engendrer des courts-circuits lorsqu'on enlève l'oxyde conducteur le long du contour des électrodes selon deux lignes de détourage concentriques ne s'additionnent pas mais se multiplient, de sorte que la probabilité résultante est sensiblement inférieure aux probabilités dont elle est le produit. De même, on réduit sensiblement les risques de couplages capacitifs parasites entre les zones actives de la couche d'ITO qui constituent les électrodes et qui sont destinées à être portées à un potentiel électrique et les zones flottantes de cette couche qui ne sont reliées à aucun potentiel.

En effet, la capacité parasite C qui s'établit entre deux électrodes de largeur w et distantes de d est donnée par la relation : C = ε₀*εᵣ*w/d où ε₀ est la constante diélectrique du vide et εᵣ est la constante diélectrique relative du substrat sur lequel sont structurées les électrodes. Ainsi, à largeur w constante, lorsque l'on rapproche les électrodes les unes des autres, la capacité parasite résultante C augmente. Or, détourer plusieurs fois les électrodes équivaut à relier entre eux plusieurs condensateurs en série. Sachant que la capacité équivalent à n condensateurs de capacité C montés en série est égale à C/n où n est un nombre entier naturel, plus le nombre de condensateurs montés en série est grand, autrement dit plus le nombre de traits de détourages autour des électrodes est élevé, plus la capacité parasite résultante sera faible.

Selon une variante simplifiée de mise en oeuvre du procédé selon l'invention, on peut se contenter d'enlever l'oxyde le long du contour des électrodes selon un seul trait de détourage, tout en prenant des mesures de sauvegarde pour pallier tout problème de couplage capacitif résiduel.

A cet effet, et selon un second aspect de l'invention, on segmente la partie flottante 14 de la couche d'ITO en régions 16 électriquement isolées les unes des autres en enlevant l'ITO le long de lignes de séparation 18. Ce faisant, on évite les risques de couplages capacitifs parasites entre les électrodes et les zones flottantes de la couche d'ITO via le doigt.

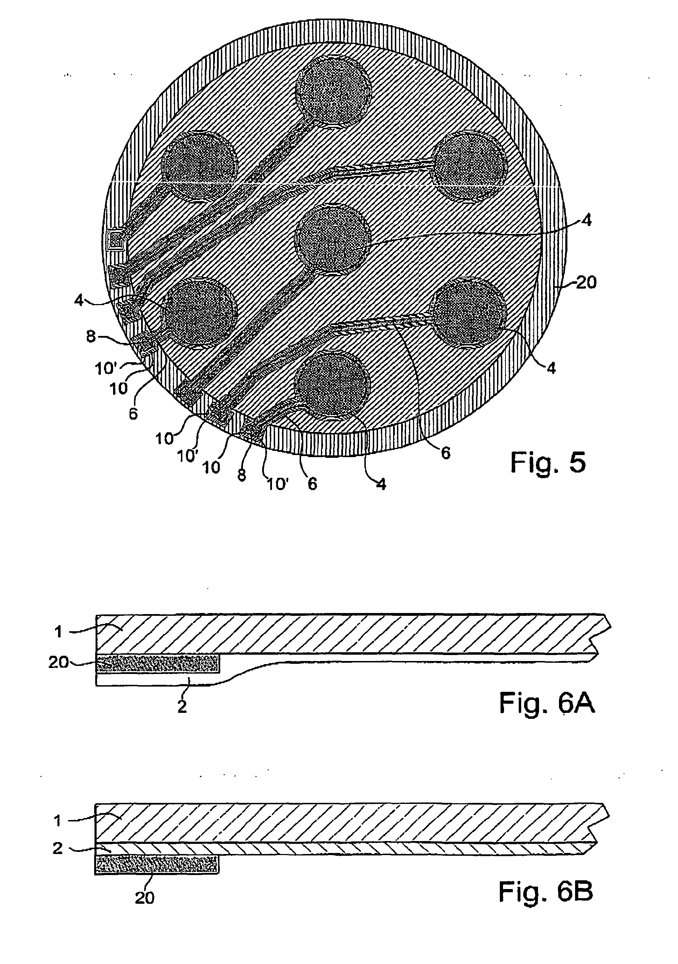

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées. En particulier, on peut envisager, malgré la faible largeur des traits de détourage, de compenser optiquement ces derniers par dépôts successifs d'une première couche d'un diélectrique transparent ayant un indice de réfraction faible et d'une deuxième couche d'un autre diélectrique ayant un indice de réfraction élevé par rapport à celui de la première couche comme enseigné par la demande de brevet européen No. 03028874.0 au nom de la Demanderesse. Dans le cas de la glace de montre, on peut également envisager d'appliquer le procédé selon l'invention à une couche de métallisation 20 déposée le long du pourtour de ladite glace 1 comme illustré à la figure 5. Selon une première variante, on dépose une couche d'ITO sur toute la surface de la glace puis on dépose la couche de métallisation par-dessus ladite couche d'ITO (voir figure 5A). Selon une seconde variante illustrée à la figure 5B, on dépose d'abord la couche de métallisation sur le pourtour de la glace, puis on dépose la couche d'ITO de façon que cette demière recouvre au moins partiellement ladite couche de métallisation. Après quoi, on détoure les électrodes 4, les pistes conductrices 6 et les plages de contact 8 selon deux traits de détourage 10 et 10' concentriques de façon à enlever à la fois l'ITO et la couche de métallisation au niveau des plages de contact 8. Enfin, il va de soi que le double détourage des électrodes et la segmentation de la partie flottante de la couche d'oxyde peuvent être combinés.

## Revendications

1. Procédé de fabrication d'un élément transparent comprenant des électrodes également transparentes, ce procédé comprenant les étapes qui consistent à :
- déposer sur au moins une partie de la surface d'un substrat transparent (1) une couche (2) d'un oxyde conducteur également transparent, et
- structurer dans la couche d'oxyde conducteur (2) au moins une électrode (4) reliée à une plage de contact (8) par une piste conductrice (6) en enlevant ledit oxyde le long du contour de l'électrode (4, 6, 8) recherchée de façon à créer un trait de détourage (10) qui va isoler la partie (12) de la couche d'oxyde conducteur (2) qui constitue l'électrode (4, 6, 8) et qui est destinée à être portée à un potentiel électrique du reste (14) de la couche d'oxyde conducteur (2) qui elle sera flottante,
ce procédé étant **caractérisé en ce que** l'on réalise au moins un second trait de détourage (10') autour du premier (10).

2. Procédé de fabrication d'un élément transparent comprenant des électrodes également transparentes, ce procédé comprenant les étapes consistant à:
- déposer sur au moins une partie de la surface d'un substrat transparent (1) une couche (2) d'un oxyde conducteur également transparent, et
- structurer dans la couche d'oxyde conducteur (2) au moins une électrode (4) reliée à une plage de contact (8) par une piste conductrice (6) en enlevant ledit oxyde le long du contour de l'électrode (4, 6, 8) recherchée de façon à créer un trait de détourage (10) qui va isoler la partie active (12) de la couche d'oxyde conducteur (2) qui constitue l'électrode (4, 6, 8) et qui est destinée à être portée à un potentiel électrique du reste (14) de la couche d'oxyde conducteur (2) qui elle sera flottante,
ce procédé étant **caractérisé en ce que** l'on segmente la couche d'oxyde conducteur flottante (14) en au moins deux parties distinctes (16) non reliées électriquement entre elles en enlevant ledit oxyde selon une ligne de séparation (18).

3. Procédé de fabrication d'un élément transparent comprenant des électrodes également transparentes, ce procédé comprenant les étapes qui consistent à :
- déposer sur au moins une partie de la surface d'un substrat transparent (1) une couche (2) d'un oxyde conducteur également transparent, et
- structurer dans la couche d'oxyde conducteur (2) au moins une électrode (4) reliée à une plage de contact (8) par une piste conductrice (6) en enlevant ledit oxyde le long du contour de l'électrode (4, 6, 8) recherchée de façon à créer un trait de détourage (10) qui va isoler la partie (12) de la couche d'oxyde conducteur (2) qui constitue l'électrode (4, 6, 8) et qui est destinée à être portée à un potentiel électrique du reste (14) de la couche d'oxyde conducteur (2) qui elle sera flottante,
ce procédé étant **caractérisé en ce que** l'on réalise au moins un second trait de détourage (10') autour du premier (10) et **en ce que** l'on segmente la couche d'oxyde conducteur flottante (14) en au moins deux parties distinctes (16) non reliées électriquement entre elles en enlevant ledit oxyde selon une ligne de séparation (18).

4. Procédé selon l'une quelconque des revendications 1 ou 3, **caractérisé en ce que**, après dépôt de la couche (2) d'oxyde conducteur transparent, on dépose sur le pourtour du substrat (1) une couche de métallisation (20) par-dessus ladite couche d'oxyde conducteur (2), puis on détoure les électrodes (4), les pistes conductrices (6) et les plages de contact (8) selon les traits de détourage (10, 10') de façon à enlever à la fois l'oxyde conducteur et la couche de métallisation au niveau des plages de contact (8).

5. Procédé selon l'une quelconque des revendications 1 ou 3, **caractérisé en ce que** l'on dépose d'abord une couche de métallisation (20) sur le pourtour du substrat (1), puis on dépose la couche (2) d'oxyde conducteur transparent de façon que cette couche d'oxyde (2) recouvre au moins partiellement ladite couche de métallisation (20), puis on détoure les électrodes (4), les pistes conductrices (6) et les plages de contact (8) selon les traits de détourage (10, 10') de façon à enlever à la fois l'oxyde conducteur et la couche de métallisation au niveau des plages de contact (8).

6. Procédé selon l'une quelconque des revendications 1 à 5, **caractérisé en ce que** l'on compense optiquement les traits de détourage (10, 10') et les lignes de séparation (18) par dépôt d'au moins une couche de compensation optique.

7. Procédé selon la revendication 6, **caractérisé en ce que** l'on dépose successivement une première couche d'un matériau diélectrique transparent ayant un indice de réfraction faible et une deuxième couche d'un autre matériau diélectrique transparent ayant un indice de réfraction élevé par rapport à celui de la première couche.

8. Procédé selon l'une quelconque des revendications 1 à 7, **caractérisé en ce que** la largeur des lignes de détourage et de séparation est comprise entre 1 µm et 10 µm et est de préférence égale à 5 µm.

9. Dispositif comprenant un substrat transparent (1) recouvert au moins en partie d'une couche (2) d'oxyde conducteur également transparent dans laquelle est structurée au moins une électrode (4), un trait de détourage (10) séparant la partie active (12) de la couche d'oxyde conducteur (2) qui constitue l'électrode (4) et qui est portée à un potentiel électrique du reste (14) de la couche d'oxyde conducteur (2) qui elle est flottante, **caractérisé en ce qu'**il comprend un second trait de détourage (10') formé autour du premier (10) pour éviter un couplage capacitif parasite entre la partie active (12) et la partie flottante (14) de ladite couche d'oxyde conducteur (2).

10. Dispositif comprenant un substrat transparent (1) recouvert au moins en partie d'une couche (2) d'oxyde conducteur également transparent dans laquelle est structurée au moins une électrode (4), un trait de détourage (10) séparant la partie active (12) de la couche d'oxyde conducteur (2) qui constitue l'électrode (4) et qui est portée à un potentiel électrique du reste (14) de la couche d'oxyde conducteur (2) qui elle est flottante, **caractérisé en ce qu'**il comprend une ligne (18) de séparation qui segmente la partie flottante (14) de la couche d'oxyde conducteur (2) en au moins deux zones distinctes (16) non reliées électriquement pour éviter un couplage capacitif parasite entre la partie active (12) et la partie flottante (14) de ladite couche d'oxyde conducteur (2).

## Claims

1. Method of manufacturing a transparent element including transparent electrodes, said method including the steps of:
- depositing over at least one part of the surface of a transparent substrate (1) a layer (2) of a conductive oxide that is also transparent, and
- structuring in said conductive oxide layer (2) at least one electrode (4) connected to a contact pad (8) by a conductive path (6) by removing said oxide along the contour of the desired electrode (4, 6, 8) so as to create a trimming line (10) which will insulate the part (12) of the conductive oxide layer (2), which forms the electrode (4, 6, 8) and which is to be brought to an electric potential, from the rest (14) of the conductive oxide layer (2) which will be floating,
- this method being **characterized in that** at least a second trimming line (10') is made around the first trimming line (10).

2. Method of manufacturing a transparent element including transparent electrodes, said method including the steps of:
- depositing over at least one part of the surface of a transparent substrate (1) a layer (2) of a transparent conductive oxide (2), and
- structuring in the conductive oxide layer (2) at least one electrode (4) connected to a contact pad (8) by a conductive path (6) by removing said oxide along the contour of the desired electrode (4, 6, 8) so as to create a trimming line (10) which will insulate the active part (12) of the conductive oxide layer (2), which forms the electrode (4, 6, 8) and which will be brought to an electric potential, from the rest (14) of the conductive oxide layer (2) which will be floating,
said method being **characterized in that** the floating conductive oxide layer (14) is segmented into at least two distinct parts (16) that are not electrically connected to each other, by removing said oxide along a line of separation (18).

3. Method of manufacturing a transparent element including transparent electrodes, this method including the steps of:
- depositing over at least one part of the surface of a transparent substrate (1) a layer (2) of a conductive oxide that is also transparent, and
- structuring in said conductive oxide layer (2) at least one electrode (4) connected to a contact pad (8) by a conductive path (6) by removing said oxide along the contour of the desired electrode (4, 6, 8) so as to create a trimming line (10) which will insulate the part (12) of the conductive oxide layer (2), which forms the electrode (4, 6, 8) and which is to be brought to an electric potential, from the rest (14) of the conductive oxide layer (2) which will be floating,
- this method being **characterized in that** at least a second trimming line (10') is made around the first trimming line (10) and **in that** the floating conductive oxide layer (14) is segmented into at least two distinct parts (16) that are not electrically connected to each other, by removing said oxide along a line of separation (18).

4. Method according to any of claims 1 or 3, **characterized in that**, after the transparent conductive oxide layer (2) has been deposited, a metallization layer (20) is deposited on the periphery of the substrate (1) above said conductive oxide layer (2), then the electrodes (4), the conductive paths (6) and the contact pads (8) are trimmed along the trimming lines (10, 10') so as to remove both the conductive oxide and the metallization layer on the contact pads (8).

5. Method according to any of claims 1 or 3, **characterized in that** a metallization layer (20) is first deposited on the periphery of the substrate (1), then the transparent conductive oxide layer (2) is deposited such that said oxide layer (2) at least partially covers said metallization layer (20), then the electrodes (4), the conductive paths (6) and the contact pads (8) are trimmed along the trimming lines (10, 10') so as to remove both the conductive oxide and the metallization layer on the contact pads (8).

6. Method according to any of claims 1 to 5, **characterized in that** the trimming lines (10, 10') and the separation lines (18) are optically compensated for by depositing at least one optical compensation layer.

7. Method according to claim 6, **characterized in that** a first layer of a transparent dielectric material having a low refractive index and a second layer of another transparent dielectric material having a high refraction index in relation to that of the first layer are deposited in succession.

8. Method according to any of claims 1 to 7, **characterized in that** the width of the trimming and separation lines is comprised between 1 µm and 10 µm and is preferably equal to 5 µm.

9. Device including a transparent substrate (1) at least partly covered with a transparent conductive oxide layer (2) in which at least one electrode (4) is structured, a trimming line (10) separating the active part (12) of the conductive oxide layer (2), which forms the electrode (4) and which is brought to an electric potential, from the rest (14) of the conductive oxide layer (2), which is floating, **characterized in that** it comprises a second trimming line (10') made around the first trimming line (10) to prevent stray capacitive coupling between the active part (12) and the floating part (14) of said conductive oxide layer (2).

10. Device comprising a transparent substrate (1) at least partly covered with a transparent conductive oxide layer (2) in which is structured at least one electrode (4), a trimming line (10) separating the active part (12) of the conductive oxide layer (2), which forms the electrode (4) and which is brought to an electric potential from the rest (14) of the conductive oxide layer (2) which is floating, **characterized in that** it comprises a line of separation (18) which segments the floating part (14) of the conductive oxide layer (2) into at least two distinct parts (16) that are not electrically connected to avoid a stray capacitive coupling between the active part (12) and the floating part (14) of said conductive oxide layer (2).

## Patentansprüche

1. Verfahren zum Herstellen eines transparenten Elements mit ebenfalls transparenten Elektroden, wobei dieses Verfahren die folgenden Schritte umfasst:
- Aufbringen einer Schicht (2) aus einem ebenfalls transparenten leitfähigen Oxid auf zumindest einen Teil der Oberfläche eines transparenten Substrats (1),
- Einbringen zumindest einer über eine Leiterbahn (6) mit einem Kontaktbereich (8) verbundenen Elektrode (4) in die leitfähige Oxidschicht (2), indem das Oxid entlang der Kontur der vorgesehenen Elektrode (4, 6, 8) entfernt wird, so dass ein Schneidstreifen (10) geschaffen wird, der denjenigen Teil (12) von der leitfähigen Oxidschicht (2) isoliert, der die Elektrode (4, 6, 8) bildet und dazu bestimmt ist, auf ein elektrisches Potential des restlichen Teils (14) der leitfähigen Oxidschicht (2) gelegt zu werden, die dagegen schwimmend ist,
wobei dieses Verfahren **dadurch gekennzeichnet ist, dass** zumindest ein zweiter Schneidstreifen (10') um den ersten (10) herum erzeugt wird.

2. Verfahren zum Herstellen eines transparenten Elements mit ebenfalls transparenten Elektroden, wobei dieses Verfahren die folgenden Schritte umfasst:
- Aufbringen einer Schicht (2) aus einem ebenfalls transparenten leitfähigen Oxid auf zumindest einen Teil der Oberfläche eines transparenten Substrats (1),
- Einbringen zumindest einer über eine Leiterbahn (6) mit einem Kontaktbereich (8) verbundenen Elektrode (4) in die leitfähige Oxidschicht (2), indem das Oxid entlang der Kontur der vorgesehenen Elektrode (4, 6, 8) entfernt wird, so dass ein Schneidstreifen (10) geschaffen wird, der den aktiven Teil (12) von der leitfähigen Oxidschicht (2) isoliert, der die Elektrode (4, 6, 8) bildet und dazu bestimmt ist, auf ein elektrisches Potential des restlichen Teils (14) der leitfähigen Oxidschicht (2) gelegt zu werden, die dagegen schwimmend ist,
wobei dieses Verfahren **dadurch gekennzeichnet ist, dass** die schwimmende leitfähige Oxidsschicht (14) in zumindest zwei verschiedene Teile (16) segmentiert wird, die nicht elektrisch miteinander verbunden sind, indem das Oxid entlang einer Trennlinie (18) entfernt wird.

3. Verfahren zum Herstellen eines transparenten Elements mit ebenfalls transparenten Elektroden, wobei dieses Verfahren die folgenden Schritte umfasst:
- Aufbringen einer Schicht (2) aus einem ebenfalls transparenten leitfähigen Oxid auf zumindest einen Teil der Oberfläche eines transparenten Substrats (1),
- Einbringen zumindest einer über eine Leiterbahn (6) mit einem Kontaktbereich (8) verbundenen Elektrode (4) in die leitfähige Oxidschicht (2), indem das Oxid entlang der Kontur der vorgesehenen Elektrode (4, 6, 8) entfernt wird, so dass ein Schneidstreifen (10) geschaffen wird, der denjenigen Teil (12) von der leitfähigen Oxidschicht (2) isoliert, der die Elektrode (4, 6, 8) bildet und dazu bestimmt ist, auf ein elektrisches Potential des restlichen Teils (14) der leitfähigen Oxidschicht (2) gelegt zu werden, die dagegen schwimmend ist,
wobei dieses Verfahren **dadurch gekennzeichnet ist, dass** zumindest ein zweiter Schneidstreifen (10') um den ersten (10) herum erzeugt wird und dass die schwimmende leitfähige Oxidsschicht (14) in zumindest zwei verschiedene Teile (16) segmentiert wird, die nicht elektrisch miteinander verbunden sind, indem das Oxid entlang einer Trennlinie (18) entfernt wird,

4. Verfahren nach einem der Ansprüche 1 oder 3, **dadurch gekennzeichnet, dass** nach Aufbringen der Schicht (2) aus transparentem, leitfähigen Oxid am Umfang des Substrats (2) eine Metallisierungsschicht (20) über die leitfähige Oxidschicht (2) aufgebracht wird, dann die Elektroden (4), die Leiterbahnen (6) und die Kontaktbereiche (8) entlang der Schneidstreifen (10, 10') so ausgeschnitten werden, dass zugleich das leitfähige Oxid und die Metallisierungsschicht bei den Kontaktbereichen (8) entfernt werden.

5. Verfahren nach einem der Ansprüche 1 oder 3, **dadurch gekennzeichnet, dass** zunächst eine Metallisierungsschicht (20) am Umfang des Substrats (1) aufgebracht wird, dass die Schicht (2) aus transparentem leitfähigen Oxid so aufgebracht wird, dass diese Oxidschicht (2) zumindest teilweise die Metallisierungsschicht (20) überdeckt, und dann die Elektroden (4), die Leiterbahnen (6) und die Kontaktbereiche (8) entlang der Schneidstreifen (10, 10') so ausgeschnitten werden, dass zugleich das leitfähige Oxid und die Metallisierungsschicht bei den Kontaktbereichen (8) entfernt werden.

6. Verfahren nach einem der Ansprüche 1 bis 5, **dadurch gekennzeichnet, dass** die Schneidstreifen (10, 10') und die Trennlinien (18) durch Aufbringen zumindest einer optischen Kompensationsschicht optisch kompensiert werden.

7. Verfahren nach Anspruch 6, **dadurch gekennzeichnet, dass** eine erste Schicht aus einem transparenten dielektrischen Material mit einem geringen Brechungsindex und eine zweite Schicht aus einem anderen transparenten dielektrischen Material mit einem bezüglich der ersten Schicht hohen Brechungsindex nacheinander aufgebracht werden.

8. Verfahren nach einem der Ansprüche 1 bis 7, **dadurch gekennzeichnet, dass** die Breite der Schneid- und Trennlinien zwischen 1 µm und 10 µm und vorzugsweise gleich 5 µm ist.

9. Vorrichtung mit einem transparenten Substrat (1), das zumindest teilweise mit einer Schicht (2) aus ebenfalls transparentem leitfähigen Oxid überdeckt ist, in welcher zumindest eine Elektrode (4) eingebracht ist, wobei ein Scheidstreifen (10) den aktiven Teil (12) von der leitfähigen Oxidschicht (2) trennt, der die Elektrode (4) bildet und auf ein elektrisches Potential des restlichen Teils (14) der leitfähigen Oxidschicht (2) gelegt wird, die dagegen schwimmend ist, **dadurch gekennzeichnet, dass** sie einen zweiten Schneidstreifen (10') aufweist, der um den ersten (10) herum ausgebildet ist, um eine kapazitive Störkopplung zwischen dem aktiven Teil (12) und dem schwimmenden Teil (14) der leitfähigen Oxidschicht (2) zu vermeiden.

10. Vorrichtung mit einem transparenten Substrat (1), das zumindest teilweise mit einer Schicht (2) aus ebenfalls transparentem leitfähigen Oxid überdeckt ist, in welcher zumindest eine Elektrode (4) eingebracht ist, wobei ein Scheidstreifen (10) den aktiven Teil (12) von der leitfähigen Oxidschicht (2) trennt, der die Elektrode (4) bildet und auf ein elektrisches Potential des restlichen Teils (14) der leitfähigen Oxidschicht (2) gelegt wird, die dagegen schwimmend ist, **dadurch gekennzeichnet, dass** sie eine Trennlinie (18) aufweist, die den schwimmenden Teil (14) der leitfähigen Oxidschicht (2) in zumindest zwei verschiedene Bereiche (16) segmentiert, die nicht elektrisch verbunden sind, um eine kapazitive Störkopplung zwischen dem aktiven Teil (12) und dem schwimmenden Teil (14) der leitfähigen Oxidschicht (2) zu vermeiden.
